# EUROPEAN PATENT SPECIFICATION

(11) **EP 3 409 616 B1**
(45) Date of publication and mention of the grant of the patent: **02.08.2023**
(21) Application number: 17196856.3
(22) Date of filing: 17.10.2017
(51) Int. Cl.: B65D 81/32

(54) **WIPER KIT FOR CLEANING**
WISCHERSATZ ZUR REINIGUNG
KIT D'ESSUIE-GLACE POUR LE NETTOYAGE

(30) Priority: 02.06.2017 KR 20170069241 P
(43) Date of publication of application: 05.12.2018
(73) Proprietor: KM Corp., Gangwon-do 25369 (KR)
(72) Inventor: Kang, Seong-Bong, 17597 Gyeonggi-do (KR); Lee, Jae-Yong, 17599 Gyeonggi-do (KR)
(74) Representative: Høiberg P/S

(56) References cited:
- JP-A- 2003 002 364
- JP-A- 2007 223 642
- KR-B1- 101 360 249
- KR-B1- 101 390 978
- US-A- 6 001 187
- US-A1- 2011 308 977
- US-A1- 2016 353 944

## Description

### TECHNICAL FIELD

The present disclosure relates to a wiper kit for cleaning, and more particularly, to a wiper kit for cleaning which has an improved structure for discharging a cleaning liquid from an inside of a bag accommodating a wiper and a cleaning liquid toward the wiper.

### BACKGROUND

Generally, facilities requiring extreme cleanliness and aseptic conditions, such as semiconductor/display manufacturing devices and pharmaceutical manufacturing devices, are installed in a clean room, and these facilities are cleaned by a dedicated clean wiper and a cleaning liquid to keep a clean state at all times in order to prevent contamination.

Commonly, a wiper used for cleaning a semiconductor wafer, a device, an instrument or the like in a clean room is prepared by weaving or knitting a fiber material which is excellent in adsorption of dust and moisture and may suppress dust generation in use.

The wiper is hermetically packaged in a container such as a flexible resin bag or the like and distributed. An operator opens the flexible resin bag, takes out the wiper, puts a chemical cleaning liquid such as ethanol or acetone stored in a separate container on the wiper, and then wipes a surface of an object with the wiper.

However, a conventional wiper may cause a safety accident while discharging a dangerous volatile chemical agent stored in a separate container from the container and puts the chemical agent on the wiper. In addition, a residual chemical component or polymer (oligomer, or the like) of the wiper is eluted by the volatile chemical agent, so that nonvolatile residues eluted in a following cleaning work remain on the cleaned surface. Moreover, since it is not easy for the operator to control a proper amount of the volatile chemical agent, there is a weak point that an inefficient cleaning work such as supersaturation of the agent may occur.

As an alternative to the above, a product hermetically packaged in a state where a predetermined amount of cleaning liquid is applied to a wiper in advance to be saturated has been proposed. However, this product is disadvantageous in that fibers used as a material of the wiper are contaminated or damaged as the cleaning liquid is in contact with the wiper in the container for long time, and more ions and impurities may be released. In addition, if the cleaning liquid contains a component such as a biological poison, its efficacy may be deteriorated due to the contamination.

As another alternative, Patent Literature 1 (Korean Unexamined Patent Publication No. 1998-702916) discloses a cleaning device, which includes an outer container accommodating a wiper and an inner container received in the outer container and accommodating a cleaning liquid, wherein, as a pressure is applied to the outer container by the hand of a user, the is transferred to the inner container to perforate and open the inner container so that the cleaning liquid is discharged to the wiper from the inside the outer container. KR101360249 discloses a sealed wiper kit for cleaning, which accords with the preamble of claim 1, US20160353944 discloses a pouch for internal mixture of segregated reactants and applications thereof, and JP2003002364 discloses a packaged object.

However, the cleaning device has a weak point that the inner container may be ruptured due to a strong physical impact applied from the outside when the outer container is handled, so that the cleaning liquid is discharged to the wiper unwillingly. By this, the cleaning device may lose its commercial value.

### SUMMARY

### Technical Problem

The present disclosure is designed to solve the problems of the related art, and therefore the present disclosure is directed to providing a wiper kit for cleaning which has an improved structure for opening an inner container accommodating a cleaning liquid by rupturing the inner container.

### Technical Solution

The invention is defined by a wiper kit for cleaning, comprising:an outer bag having an inner space accommodating a wiper;an inner bag provided at one inner side of the outer bag and hermetically containing a cleaning liquid therein; and an opening member connected to the inner bag and extending toward an outlet of the outer bag; and a grip provided by folding at least a part of the outer bag in a zigzag pattern and connected to the opening member,wherein the opening member is connected to the inner bag so that the inner bag is ruptured by pulling the opening member,wherein when the inner bag is ruptured, the cleaning liquid is discharged and applied to the wiper inside the outer bag,wherein a cutoff line is formed at the inner bag, and wherein when the opening member is pulled, the inner bag is ruptured along the cutoff line, wherein the opening member is connected to the inner bag so that the inner bag is ruptured by pulling the opening member in association with an operation of pulling the grip out of the outer bag in a state where the outer bag is sealed, wherein the folding portion and the grip are located in a region between one edge of the outer bag and a longitudinal midpoint of the outer bag, and wherein the folding portion and the grip are disposed at one side of a flat portion which is spaced at a predetermined distance from the end of the outer bag.

The cutoff line may be formed with at least a pair of dotted lines, and the pair of dotted lines may be formed parallel to each other with a predetermined width in a predetermined region.

As an alternative, the cutoff line may be formed with at least a pair of dotted lines, and the pair of dotted lines may be formed to have a width gradually increasing from one end of the inner bag toward the other end thereof.

The opening member may have a resin ribbon structure connected to the cutoff line and extending toward the outlet of the outer bag.

The inner bag may be made of a resin sheet, and among edges of the inner bag, at least one edge may be sealed together with the outer bag in a state of being interposed in one edge of the outer bag.

According to the invention, the wiper kit for cleaning, comprises a grip provided by folding at least a part of the outer bag in a zigzag pattern and connected to the opening member, and the opening member is connected to the inner bag so that the inner bag is ruptured by pulling the opening member in association with an operation of pulling the grip out of the outer bag in a state where the outer bag is sealed, where the folding portion and the grip are located in a region between one edge of the outer bag and a longitudinal midpoint of the outer bag, and the folding portion and the grip are disposed at one side of a flat portion which is spaced at a predetermined distance from the end of the outer bag.

The inner bag may be made of a resin sheet, and a peripheral edge of the resin sheet may be sealed to an inner surface of the outer bag, and the opening member may have a resin sheet or ribbon structure connected to the resin sheet and extending opposite to the outlet of the outer bag.

The wiper may be prepared by weaving or knitting a fiber material, and the wiper is provided in plural so that a plurality of wipers are stacked adjacent to the inner bag inside the outer bag, and the cleaning liquid may be a volatile chemical agent.

### Advantageous Effects

The wiper kit for cleaning according to the present disclosure has the following effects.

First, when the opening member is pulled, the inner bag may be ruptured easily and precisely due to the cutoff line, and thus it is possible to prevent problems such as rupture failure or fragment generation, caused by deviation or cutting of the opening member.

Second, it is possible to easily discharge the cleaning liquid just by pulling the opening member in use and then apply the cleaning liquid to the wiper, and thus the wiper kit for cleaning may be used conveniently and safely.

Third, even though a strong physical impact is applied from the outside before use, the inner bag is not opened as long as the opening member is not intentionally pulled, thereby ensuring excellent product stability.

Fourth, the inner bag may be opened by pulling a part of the outer bag in a sealed state, and thus an operator may be safely protected from the chemical cleaning liquid.

The invention is defined by the claims. Any subject matter falling outside the scope of the claims is provided for information purposes only

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a partially sectioned perspective view showing a general example of a wiper kit for cleaning .
FIG. 2 is a cross-sectioned view, taken along the line A-A' of the general example of FIG. 1.
FIGS. 3 to 5 are plane views showing patterns of a cutoff line formed at an inner bag, e.g. of the general example depicted in FIG. 1.
FIG. 6 is a cross-sectioned view showing a state where an opening member is pulled to rupture and open the inner bag of the general example in FIG. 2.
FIG. 7 is a partially sectioned perspective view showing a wiper kit for cleaning according to a general example.
FIG. 8 is a cross-sectioned view, taken along the line B-B' of the general example of FIG. 7.
FIG. 9 is a cross-sectioned view showing a state where an opening member is pulled using a grip to rupture and open the inner bag of the general example in FIG. 8.
FIG. 10 is a cross-sectioned view showing a modification of FIG. 7 according to the present invention.
FIG. 11 is a schematic plane view showing another modification of FIG. 7, as a general example.

### DISCLOSURE AND BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the description proposed herein is just a preferable example for the purpose of illustrations only, not intended to limit the scope of the disclosure, so it should be understood that other equivalents and modifications could be made thereto without departing from the scope of the disclosure.

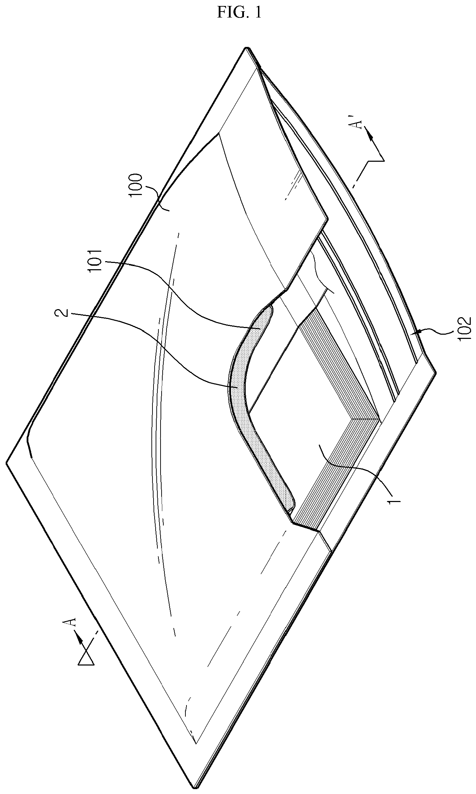

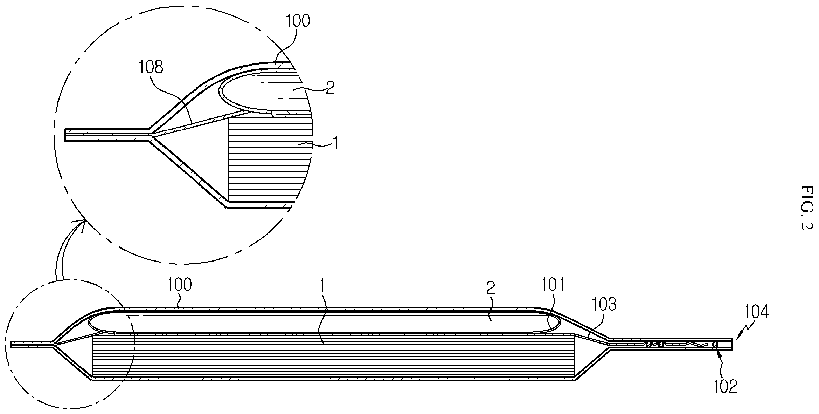

FIG. 1 is a partially sectioned perspective view showing a general example of a wiper kit for cleaning, and FIG. 2 is a cross-sectioned view, taken along the line A-A' of the general example of FIG. 1.

Referring to FIGS. 1 and 2, a wiper kit for cleaning generally includes an outer bag 100 accommodating a wiper 1, an inner bag 101 provided in an inner space of the outer bag 100 and hermetically containing a cleaning liquid 2 therein, and an opening member 103 connected to the inner bag 101 and extending toward an outlet 104 of the outer bag 100.

The outer bag 100 has an inner space for accommodating the wiper 1 and the inner bag 101. The outer bag 100 may be preferably formed using, for example, a flexible lamination resin made of polyethylene. Here, the wiper 1 is prepared by weaving or knitting a fiber material capable of cleaning internal facilities of a clean room, and a plurality of wipers 1 are stacked and disposed adjacent to the inner bag 101.

One edge of the outer bag 100 is configured to be capable of opening in order to take off the wiper 1 during a cleaning work. One edge of the outer bag 100 may be opened by cutting with scissors or the like. A zipper structure 102 composed of a protrusion and a groove as a pair along a width direction may be provided at the outlet 104 of the outer bag 100 so that only wipers 1 may be taken out as many as necessary during a cleaning work and then the rest wipers may be temporarily stored in a clean state.

The inner bag 101 is connected to one inner side of the outer bag 100, and the cleaning liquid 2 is enclosed therein. In order to connect and fix the inner bag 101 to the outer bag 100, a fixing ribbon 108 of a predetermined length may be added to the outer bag 100 so that the fixing ribbon 108 is interposed in one edge of the outer bag 100.

The inner bag 101 is formed using a resin sheet such as transparent vinyl. At this time, a peripheral edge of the resin sheet is sealed to one inner side of the outer bag 100 to form an inner space capable of accommodating the cleaning liquid 2. Here, the cleaning liquid 2 may employ a chemical cleaning agent such as ethanol, acetone, NMP, IPA, a mixture of ethanol and acetone mixture, or the like.

Among the peripheral edge of the inner bag 101, at least one side is more preferably sealed together with the outer bag 100 in a state where the side is interposed in the edge of the outer bag 100. In this configuration, the cleaning liquid is received in the inner bag 101 through the edge in a state where the other portions than the edge of the inner bag 101 is sealed, and after that, the outer bag 100 and the inner bag 101 are sealed simultaneously in a state where the edge is interposed in a portion of the edge of the outer bag 100. In this case, the number of processes may be reduced for sealing.

The opening member 103 may be integrally formed with a part of the resin sheet which constitutes the inner bag 101 or alternatively may be attached to a part of the resin sheet which constitutes the inner bag 101. The opening member 103 has a resin ribbon structure extending from the resin sheet constituting the inner bag 101 toward the outlet 104 of the outer bag 100. An end portion of the opening member 103 is preferably accommodated inside the outer bag 100 so as not to be exposed to the outside.

If the opening member 103 is pulled toward the outlet 104 of the outer bag 100 in a state where the outer bag 100 is opened, a part of the resin sheet of the inner bag 101 connected to the opening member 103 is torn so that the inner bag 101 is ruptured and opened.

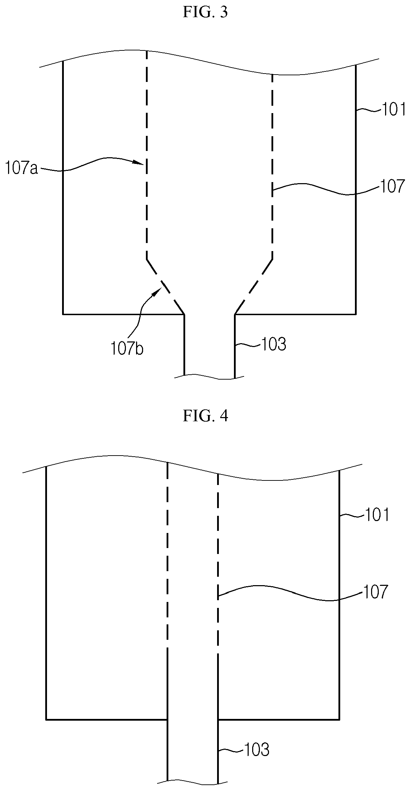

As shown in FIG. 3, a cutoff line 107 is formed at the inner bag 101 so that the inner bag 101 may be ruptured easily and accurately. If the opening member 103 is pulled toward the top of the figure, the inner bag 101 is ruptured along the cutoff line 107. The opening member 103 is formed to be connected to at least a part of the cutoff line 107 to enable this action.

The cutoff line 107 may include a first cut portion 107a in which a pair of dotted lines are formed in parallel with a predetermined width (interval), and a second cut portion 107b connected to the first cut portion 107a and having a slope so that the width of the pair of dotted lines is gradually decreased. In this case, the opening member 103 is connected to the second cut portion 107b. According to this structure, the first cut portion 107a may have various widths due to the inclined pattern of the second cut portion 107b, and the cutoff line 107 may be precisely torn. Alternatively, the opening member 103 may also be connected substantially with the same width as the pair of dotted lines of the cutoff line 107 as shown in FIG. 4.

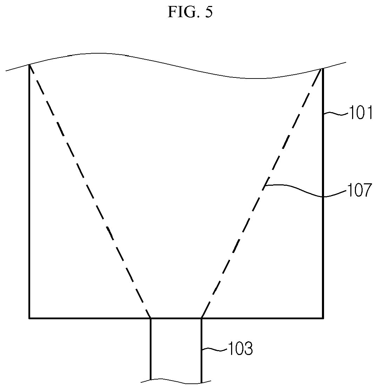

As shown in FIG. 5, the cutoff line 107 is formed to have at least one pair of dotted lines, and the pair of dotted lines may extend with a width gradually increasing from one edge of the inner bag 101 toward the other edge thereof. According to this structure, the cutoff line 107 may be smoothly torn off with a soft feeling and a sufficient rupture area may be secured.

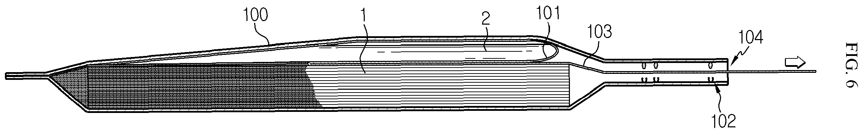

FIG. 6 shows an operation example of a general wiper kit for cleaning.

As shown in FIG. 6, if the opening member 103 is pulled, the cutoff line 107 of the inner bag 101 connected to the opening member 103 is torn so that the inner bag 101 is ruptured and opened, whereby the cleaning liquid 2 is discharged out of the inner bag 101. The discharged cleaning liquid 2 is absorbed into the wiper 1 accommodated in the outer bag 100.

Therefore, when cleaning facilities in a clean room, an operator may apply the cleaning liquid 2 to the wiper 1 quickly and safely by pulling the opening member 103 and then perform the cleaning work conveniently by opening the outer bag 100 and taking off the wiper 1.

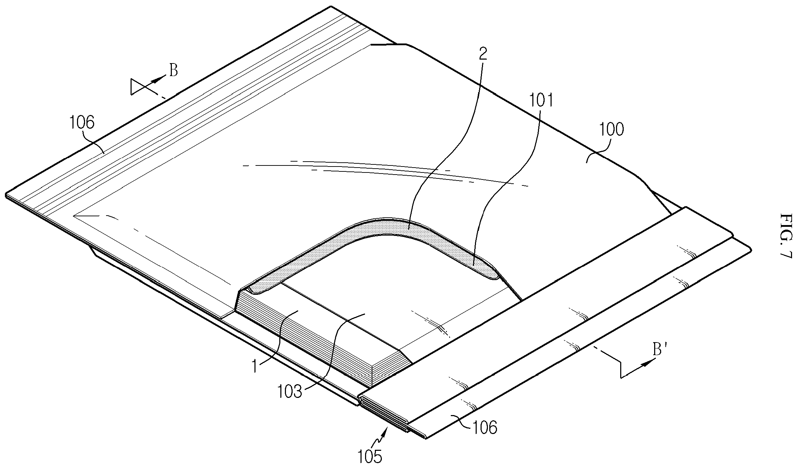

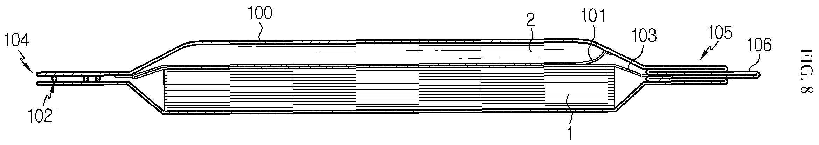

FIG. 7 is a partially sectioned perspective view showing a general example of a wiper kit for cleaning, and FIG. 8 is a cross-sectioned view, taken along the line B-B' of FIG. 7.

Referring to FIGS. 7 and 8, a general wiper kit for cleaning includes an outer bag 100 accommodating a wiper 1, an inner bag 101 provided at an inner space of the outer bag 100 and hermetically containing a cleaning liquid 2 therein, an opening member 103 connected to the inner bag 101 and extending toward an outlet 104 of the outer bag 100, and a grip 106 connected to the opening member 103 as a part of the outer bag 100.

The outer bag 100 has an inner space for accommodating the wiper 1 and the inner bag 101. The outer bag 100 may be preferably formed using, for example, a flexible lamination resin made of polyethylene. Here, the wiper 1 is prepared by weaving or knitting a fiber material capable of cleaning internal facilities of a clean room, and a plurality of wipers 1 are stacked and disposed adjacent to the inner bag 101.

One edge of the outer bag 100 is configured to be capable of opening in order to take off the wiper 1 during a cleaning work. One edge of the outer bag 100 may be opened by cutting with scissors or the like. A zipper structure 102' composed of a protrusion and a groove as a pair along a width direction may be provided at the outlet 104 of the outer bag 100 so that only wipers 1 may be taken out as many as necessary during a cleaning work and then the rest wipers may be temporarily stored in a clean state.

The inner bag 101 is connected to one inner side of the outer bag 100, and the cleaning liquid 2 is enclosed therein.

The inner bag 101 is formed using, for example, a resin sheet such as transparent vinyl. At this time, a peripheral edge of the resin sheet constituting the inner bag 101 is sealed to one inner side of the outer bag 100 to form an inner space capable of accommodating the cleaning liquid 2. Here, the cleaning liquid 2 may employ a chemical cleaning agent such as ethanol, NMP, IPA, a mixture of ethanol and acetone mixture, acetone, or the like.

The opening member 103 may be integrally formed with a part of the resin sheet which constitutes the inner bag 101 or alternatively may be attached to a part of the resin sheet which constitutes the inner bag 101. The opening member 103 has a resin ribbon structure extending from the resin sheet constituting the inner bag 101 opposite to the outlet 104 of the outer bag 100. The opening member 103 is accommodated inside the outer bag 100 so as not to be exposed to the outside and is connected to the grip 106.

The grip 106 is a part of a folding portion 105 which is formed by folding an opposite edge of the outer bag 100, namely an end of the outer bag 100 opposite to the outlet, in a zigzag pattern in a thickness direction of the outer bag 100. The grip 106 is preferably located at a central point of the zigzag pattern of the folding portion 105 and is movable in a direction opposite to the outlet of the outer bag 100. The opening member 103 is connected to the inner surface of the grip 106 by sealing. Here, the grip 106 may be protruded relative to at least one folding portion adjacent thereto so as to be easily identified.

If a user pulls the grip 106, the opening member 103 connected thereto is pulled in a direction opposite to the outlet 104 of the outer bag 100.

Similar to the former embodiment, a cutoff line 107 (see FIG. 3) is formed at the inner bag 101 so that the inner bag 101 may be ruptured easily. If the opening member 103 is pulled, the inner bag 101 is ruptured along the cutoff line 107. The opening member 103 is formed to be connected to at least a part of the cutoff line 107 to enable this action.

The cutoff line 107 includes a first cut portion 107a in which a pair of dotted lines are formed in parallel with a predetermined width, and a second cut portion 107b connected to the first cut portion 107a and having a slope so that the width of the pair of dotted lines is gradually decreased. Here, the opening member 103 may be connected to the second cut portion 107b.

Thus, if a user pulls the grip 106 out of the outer bag 100, the opening member 103 connected thereto is pulled, and the cutoff line 107 connected to the opening member 103 is torn so that the inner bag 101 is ruptured and opened. According to this structure, the inner bag 101 may be opened by pulling the grip 106, which is a part of the outer bag 100, in a state where the outer bag 100 is sealed, and thus it is possible to prevent a safety accident of an operator, caused by the chemical agent.

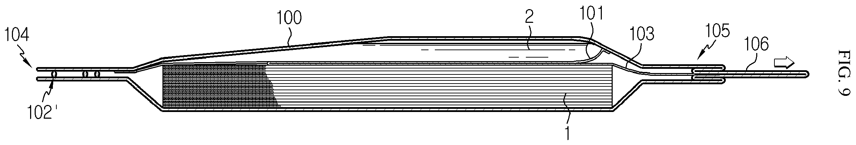

FIG. 9 shows a general operation example of a sealing-type wiper kit for cleaning having the above configuration.

As shown in FIG. 9, if the grip 106 is pulled, the grip 106 is slightly spread with respect to the folding portion 105, and the opening member 103 is pulled in conjunction with the grip 106, so that an intensive pressure is applied to the cutoff line 107 of the inner bag 101 connected to the opening member 103 . Accordingly, a portion of the resin sheet corresponding to the cutoff line 107 connected to the opening member 103 is torn to rupture and open the inner bag 101, whereby the cleaning liquid 2 is discharged out of the inner bag 101. The discharged cleaning liquid 2 is absorbed into the wiper 1 accommodated in the outer bag 100.

Therefore, when cleaning facilities in a clean room, an operator may apply the cleaning liquid 2 to the wiper 1 quickly and safely by pulling a part of the outer bag 100 to pull the opening member 103 located in the outer bag 100 so that the inner bag 101 is ruptured and opened easily, and then perform the cleaning work conveniently by opening the outer bag 100 and taking off the wiper 1.

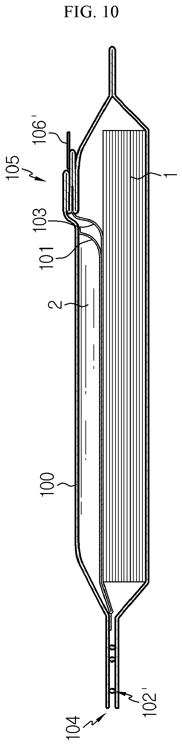

As shown in FIG. 10, the folding portion 105 and the grip 106' may also be disposed at one side of a flat portion which is spaced at a predetermined distance from the end of the outer bag 100. In this case, the opening member 103 may have as long length as necessary, compared to the case where the folding portion 105 and the grip 106' are disposed at the edge of the outer bag 100, without increasing the overall size of the product, and thus it is possible to make the rupture length of the inner bag 100 long enough. Considering this effect, it is advantageous that the folding portion 105 and the grip 106' are located in a region between the edge of the outer bag 100 and the longitudinal midpoint of the outer bag 100.

The grip 106' may be provided as a part of the folding portion 105, similar to the former embodiment, and a separate small sheet patch may be additionally attached thereto.

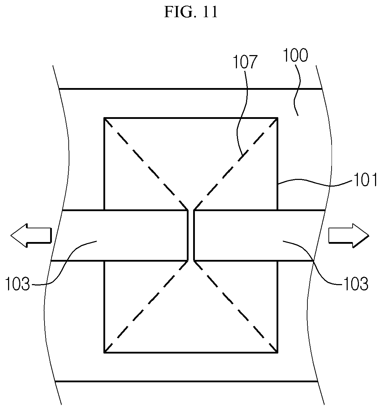

According to another general example, there is provided a wiper kit for cleaning, wherein a pair of folding portions 105 and a pair of grips 106 are provided symmetrically at both edges of the outer bag 100. In this case, as shown in FIG. 11, if the both edges of the outer bag 100 are simultaneously pulled outwardly, the opening member 103 is pulled in both opposite directions so that the cutoff line 107 is torn and the inner bag 101 is ruptured. According to this structure, it is possible to ensure a sufficient rupture area while the opening length of the opening member 103 is relatively shortened.

As described above, in the wiper kit for cleaning according to the present disclosure, since the cutoff line 107 is torn when the opening member 103 is pulled, the inner bag 101 may be ruptured easily and accurately, and also it is possible to prevent the opening member 103 from being damaged.

The present disclosure has been described in detail. However, it should be understood that the detailed description and specific examples, while indicating preferred embodiments of the disclosure, are given by way of illustration only, since various changes and modifications within the scope of the appended claims will become apparent to those skilled in the art from this detailed description.

### Reference Signs

| | | | |
|---|---|---|---|
| 1: | wiper | 2: | cleaning liquid |
| 100: | outer bag | 101: | inner bag |
| 102,102': | zipper structure | 103: | opening member |
| 105: | folding portion | 106,106': | grip |
| 104: | outlet | 107: | cutoff line |
| 107a: | first cut portion | 107b: | second cut portion |

## Claims

1. A wiper kit for cleaning, comprising:
an outer bag (100) having an inner space accommodating a wiper (1);
an inner bag (101) provided at one inner side of the outer bag and hermetically containing a cleaning liquid (2) therein; and
an opening member (103) connected to the inner bag (101) and extending toward an outlet (104) of the outer bag (100); and
a grip (106') provided by folding at least a part of the outer bag in a zigzag pattern (105) and connected to the opening member (103),
wherein the opening member (103) is connected to the inner bag (101) so that the inner bag is ruptured by pulling the opening member,
wherein when the inner bag (101) is ruptured, the cleaning liquid (2) is discharged and applied to the wiper (1) inside the outer bag (100),
wherein a cutoff line (107) is formed at the inner bag (101), and
wherein when the opening member is pulled, the inner bag is ruptured along the cutoff line,
wherein the opening member (103) is connected to the inner bag (101) so that the inner bag is ruptured by pulling the opening member in association with an operation of pulling the grip (106') out of the outer bag (100) in a state where the outer bag is sealed, **characterized**
**in that** the folding portion (105) and the grip (106') are located in a region between one edge of the outer bag (100) and a longitudinal midpoint of the outer bag (100), and in that the folding portion (105) and the grip (106') are disposed at one side of a flat portion which is spaced at a predetermined distance from the end of the outer bag (100).

2. The wiper kit for cleaning according to claim 1,
wherein the cutoff line (107) is formed with at least a pair of dotted lines, and
wherein the pair of dotted lines are formed parallel to each other with a predetermined width in a predetermined region.

3. The wiper kit for cleaning according to claim 2,
wherein the opening member (103) has a resin ribbon structure connected to the cutoff line (107) and extending toward the outlet (104) of the outer bag.

4. The wiper kit for cleaning according to claim 1,
wherein the cutoff line (107) is formed with at least a pair of dotted lines, and
wherein the pair of dotted lines are formed to have a width gradually increasing from one end of the inner bag (101) toward the other end thereof.

5. The wiper kit for cleaning according to claim 1,
wherein the inner bag (101) is made of a resin sheet, and
wherein among edges of the inner bag, at least one edge is sealed together with the outer bag (100) in a state of being interposed in one edge of the outer bag.

6. The wiper kit for cleaning according to claim 1,
wherein the inner bag (101) is made of a resin sheet, and a peripheral edge of the resin sheet is sealed to an inner surface of the outer bag (100), and
wherein the opening member (103) has a resin sheet or ribbon structure connected to the resin sheet and extending opposite to the outlet (104) of the outer bag.

7. The wiper kit for cleaning according to claim 1,
wherein the wiper (1) is prepared by weaving or knitting a fiber material, and the wiper is provided in plural so that a plurality of wipers are stacked adjacent to the inner bag (101) inside the outer bag (100), and
wherein the cleaning liquid is a volatile chemical agent.

## Patentansprüche

1. Wischersatz zur Reinigung, umfassend:
einen Außenbeutel (100) mit einem Innenraum zur Aufnahme eines Wischers (1);
einen Innenbeutel (101), der an einer Innenseite des Außenbeutels bereitgestellt ist und darin luftdicht eine Reinigungsflüssigkeit (2) enthält; und
ein Öffnungselement (103), das mit dem Innenbeutel (101) verbunden ist und sich zu einem Auslass (104) des Außenbeutels (100) erstreckt; und
einen Griff (106'), der durch Falten mindestens eines Teils des Außenbeutels in einem Zickzackmuster (105) bereitgestellt und mit dem Öffnungselement (103) verbunden ist,
wobei das Öffnungselement (103) mit dem Innenbeutel (101) derart verbunden ist, dass der Innenbeutel durch Ziehen des Öffnungselements aufgerissen wird,
wobei beim Aufreißen des Innenbeutels (101) die Reinigungsflüssigkeit (2) ausgestoßen und innerhalb des Außenbeutels (100) auf den Wischer (1) aufgebracht wird,
wobei an dem Innenbeutel (101) eine Trennlinie (107) gebildet ist und
wobei beim Ziehen des Öffnungselements der Innenbeutel entlang der Trennlinie aufgerissen wird,
wobei das Öffnungselement (103) mit dem Innenbeutel (101) derart verbunden ist, dass der Innenbeutel durch Ziehen des Öffnungselements in Verbindung mit einem Vorgang des Herausziehens des Griffs (106') aus dem Außenbeutel (100) in einem Zustand, in dem der Außenbeutel versiegelt ist, aufgerissen wird, **dadurch gekennzeichnet, dass**
sich der Faltabschnitt (105) und der Griff (106') in einem Bereich zwischen einem Rand des Außenbeutels (100) und einem Längsmittelpunkt des Außenbeutels (100) befinden und der Faltabschnitt (105) und der Griff (106') an einer Seite eines flachen Abschnitts angeordnet sind, der in einem vorbestimmten Abstand vom Ende des Außenbeutels (100) beabstandet ist.

2. Wischersatz zur Reinigung nach Anspruch 1,
wobei die Trennlinie (107) durch mindestens ein Paar gestrichelter Linien gebildet ist und
wobei das Paar gestrichelter Linien parallel zueinander mit einer vorgegebenen Breite in einem vorgegebenen Bereich gebildet ist.

3. Wischersatz zur Reinigung nach Anspruch 2,
wobei das Öffnungselement (103) eine Harzbandstruktur aufweist, die mit der Trennlinie (107) verbunden ist und sich zu dem Auslass (104) des Außenbeutels erstreckt.

4. Wischersatz zur Reinigung nach Anspruch 1,
wobei die Trennlinie (107) durch mindestens ein Paar gestrichelter Linien gebildet ist und
wobei das Paar gestrichelter Linien so gebildet ist, dass die Breite von einem Ende des Innenbeutels (101) zum dessen anderen Ende allmählich zunimmt.

5. Wischersatz zur Reinigung nach Anspruch 1,
wobei der Innenbeutel (101) aus einer Harzfolie besteht und
wobei mindestens ein Rand unter den Rändern des Innenbeutels mit dem Außenbeutel (100) in einem Zustand, in dem er in einen Rand des Außenbeutels eingefügt ist, versiegelt ist.

6. Wischersatz zur Reinigung nach Anspruch 1,
wobei der Innenbeutel (101) aus einer Harzfolie besteht und ein Umfangsrand der Harzfolie mit einer Innenfläche des Außenbeutels (100) versiegelt ist und
wobei das Öffnungselement (103) eine Harzfolie oder eine Bandstruktur aufweist, die mit der Harzfolie verbunden ist und sich gegenüber dem Auslass (104) des Außenbeutels erstreckt.

7. Wischersatz zur Reinigung nach Anspruch 1,
wobei der Wischer (1) durch Weben oder Stricken eines Fasermaterials hergestellt ist und der Wischer mehrfach bereitgestellt ist, sodass eine Vielzahl von Wischern benachbart zu dem Innenbeutel (101) innerhalb des Außenbeutels (100) gestapelt ist, und
wobei die Reinigungsflüssigkeit ein flüchtiger chemischer Wirkstoff ist.

## Revendications

1. Kit d'essuie-glace pour le nettoyage, comprenant :
un sac externe (100) ayant un espace interne logeant un essuie-glace (1) ;
un sac interne (101) disposé sur un côté interne du sac externe et contenant hermétiquement un liquide de nettoyage (2) à l'intérieur ; et
un élément d'ouverture (103) relié au sac interne (101) et s'étendant vers une sortie (104) du sac externe (100) ; et
une poignée (106') fournie en pliant au moins une partie du sac externe selon un motif en zigzag (105) et reliée à l'élément d'ouverture (103),
dans lequel l'élément d'ouverture (103) est relié au sac interne (101) de sorte que le sac interne est rompu en tirant sur l'élément d'ouverture,
dans lequel lorsque le sac interne (101) est rompu, le liquide de nettoyage (2) est déchargé et appliqué sur l'essuie-glace (1) à l'intérieur du sac externe (100),
dans lequel une ligne de coupure (107) est formée au niveau du sac interne (101), et
dans lequel lorsque l'élément d'ouverture est tiré, le sac interne est rompu le long de la ligne de coupure,
dans lequel l'élément d'ouverture (103) est relié au sac interne (101) de sorte que le sac interne est rompu en tirant sur l'élément d'ouverture en association avec une opération consistant à tirer la poignée (106') hors du sac externe (100) dans un état dans lequel le sac externe est scellé, **caractérisé en ce que** la partie pliante (105) et la poignée (106') sont situées dans une région entre un bord du sac externe (100) et un milieu longitudinal du sac externe (100), et **en ce que** la partie pliante (105) et la poignée (106') sont disposées sur un côté d'une partie plate qui est espacée à une distance prédéterminée de l'extrémité du sac externe (100).

2. Kit d'essuie-glace pour le nettoyage selon la revendication 1,
dans lequel la ligne de coupure (107) est formée d'au moins une paire de lignes pointillées, et
dans lequel la paire de lignes pointillées est formée parallèlement l'une à l'autre avec une largeur prédéterminée dans une région prédéterminée.

3. Kit d'essuie-glace pour le nettoyage selon la revendication 2,
dans lequel l'élément d'ouverture (103) a une structure de ruban de résine reliée à la ligne de coupure (107) et s'étendant vers la sortie (104) du sac externe.

4. Kit d'essuie-glace pour le nettoyage selon la revendication 1,
dans lequel la ligne de coupure (107) est formée d'au moins une paire de lignes pointillées, et
dans lequel la paire de lignes pointillées est formée pour avoir une largeur augmentant progressivement d'une extrémité du sac interne (101) vers l'autre extrémité de celui-ci.

5. Kit d'essuie-glace pour le nettoyage selon la revendication 1,
dans lequel le sac interne (101) est constitué d'une feuille de résine, et
dans lequel parmi les bords du sac interne, au moins un bord est scellé avec le sac externe (100) dans un état d'interposition dans un bord du sac externe.

6. Kit d'essuie-glace pour le nettoyage selon la revendication 1,
dans lequel le sac interne (101) est constitué d'une feuille de résine, et un bord périphérique de la feuille de résine est scellé sur une surface interne du sac externe (100), et
dans lequel l'élément d'ouverture (103) a une feuille de résine ou une structure de ruban reliée à la feuille de résine et s'étendant à l'opposé de la sortie (104) du sac externe.

7. Kit d'essuie-glace pour le nettoyage selon la revendication 1,
dans lequel l'essuie-glace (1) est préparé en tissant ou en tricotant un matériau fibreux, et l'essuie-glace est prévue en plusieurs exemplaires de sorte qu'une pluralité d'essuie-glaces sont empilées adjacentes au sac interne (101) à l'intérieur du sac externe (100), et
dans lequel le liquide de nettoyage est un agent chimique volatile.
